# EUROPEAN PATENT SPECIFICATION

(11) **EP 1 697 981 B1**
(45) Date of publication and mention of the grant of the patent: **06.04.2011**
(21) Application number: 03819093.0
(22) Date of filing: 03.12.2003
(51) Int. Cl.: H01L 21/324, H01L 21/306

(54) **PROCESS FOR IMPROVING THE SURFACE ROUGHNESS OF A SEMICONDUCTOR WAFER**
PROZESS ZUM VERBESSERN DER OBERFLÄCHENRAUIGKEIT EINES HALBLEITERWAFERS
PROCEDE POUR AMELIORER LA RUGOSITE DE SURFACE D'UNE TRANCHE DE SEMI-CONDUCTEUR

(43) Date of publication of application: 06.09.2006
(73) Proprietor: S.O.I.Tec Silicon on Insulator Technologies, 38190 Bernin (FR)
(72) Inventor: NEYRET, Eric, 38360 Sassenage (FR); MALEVILLE, Christophe, 38660 La Terrasse (FR); ECARNOT, Ludovic, 38450 VIF (FR)
(74) Representative: Collin, Jérôme
(86) International application number: PCT/IB2003/006351
(87) International publication number: WO 2005/055307

(56) References cited:
- EP-A- 1 137 069
- EP-A2- 0 684 634
- US-A1- 2002 004 305
- US-A1- 2002 127 766
- US-A1- 2003 020 096
- CELLER G. K. ET AL.: "Frontiers of silicon-on-insulator" JOURNAL OF APPLIED PHYSICS, vol. 93, no. 9, 1 May 2003 (2003-05-01), pages 4955-4978,

## Description

The present invention generally relates to the surface treatments of materials, and particularly the treatment of wafers to be used for manufacturing components for applications in microelectronics and/or optoelectronics.

More precisely, the invention concerns a process for reducing the roughness of the free surface of a semiconductor wafer, said process comprising a single annealing step for smoothing said free surface, said single annealing step being carried out as a RTA under an atmosphere of pure argon.

The term "free surface" refers to a wafer surface which is exposed to the outer environment (thus differing from a surface defined by an inner interface between two layers of a multilayer wafer).

As it will be apparent from the description, the invention can advantageously be implemented in combination with a process for making thin layers, such as described in the patent FR 2 681 472 (though such combination is not limiting the scope of the invention).

A process reproducing the teachings of the above mentioned patent is known as the Smart-Cue^{®} process. Its main steps are schematically the following :
- Implantation of species under the surface of a semiconductor donor substrate - also called "top" and made e.g. in silicon or silicon-germanium, in an implantation region of the top,
- Contact of the implanted top with a receiving substrate - also called "base",
- Cleaving the implanted top at the implantation region, in order to transfer on the base the part of said top which is located between the implanted region and the implanted surface, and thus form a thin semiconductor layer on the base.

By "implantation of species" is meant an implantation of one or more atomic or ionic species so as to introduce such species in the material of the implanted wafer, with a maximum of the concentration of the species at a determined depth of the implanted wafer, and generate an enbrittlement zone.

The case where different species are implanted is generally referred to as "co-implantation".

The depth of the enbrittlement zone in the implanted wafer is a function of the nature of the implanted species, and the energy of implantation.

In this text, the generic term "wafer" shall refer to the structure comprising a layer transferred on a base substrate, as obtained by such a Smart-Cut^{®}-type process.

And in this text the term of "wafer" furthermore generally refers to any layer, substrate or wafer, whatever its origin (Smart-Cut^{®}-type process or not). Such "wafer" can also be a wafer of bulk material according to examples not forming part of the invention.

In all cases, the general objective of the invention is to improve the roughness of the free surface of the wafer.

This objective of improving the wafer can be achieved :
- By lowering the roughness of the surface (mean roughness), but also
- by increasing the homogeneity of the roughness over the surface.

For applications such as mentioned at the beginning of this text, the roughness specifications for the free surface of the wafer are indeed very severe, and the quality of the free surface of the wafer is a parameter which is critical for the quality of the components which shall be made on the wafer.

It is e.g. common to find roughness specifications of max. 5 Angströms rms (1Å = 0.1 nm).

It is specified that roughness measurements are generally made with an AFM microscope.

With such device, the roughness is measured on surfaces scanned by the tip of the AFM microscope, the size of such surfaces being possibly between e.g. 1x1 µm² and 10x10 µm², sometimes 50x50 µm² or even 100x100 µm².

Roughness can be characterized in particular according to two main methods.

According to a first main method, roughness is said to be "high frequency roughness" ; it corresponds to scanned surfaces of about 1x1 µm².

According to the other main method, roughness is said to be "low frequency roughness"; it corresponds to scanned surfaces of about 10x10 µm² or more. The specification of 5 Angströms given above as an illustration is a roughness which typically corresponds to a scanned surface of 10x10 µm².

And wafers which are made by known processes (Smart-Cut^{®}-type process or other) present a free surface roughness which are higher than specification such as mentioned above, in the absent of a specific surface treatment such as a polishing operation.

According to a first known type of a surface treatment, the wafer undergoes a "classical" thermal treatment (e.g. sacrificial oxidation).

But such a surface treatment does not bring the roughness down to specifications as mentioned above.

It would of course be possible to multiply successive steps of classical thermal treatment and/or combining such treatments with other known surface treatments, in order to further reduce roughness.

But this would increase the time needed for such a treatment, and the complexity of the process.

A process as described in EP 1 061 565 is an illustration of such classical thermal treatment. This document discloses an annealing step carried out over a long period (about 60 minutes) with a high temperature.

This annealing is followed by a cooling under an atmosphere containing hydrogen.

According to a second known type of a surface treatment, a chemical - mechanical polishing (CMP) is applied to the free surface of the wafer.

This type of treatment can indeed reduce the roughness of the free surface of the wafer.

In the case where there is within the wafer a gradient of concentration of defaults increasing towards the surface, this second type of known surface treatment can furthermore allow the abrasion of the wafer down to a region associated to an acceptable default concentration.

But this second type of known surface treatment can possibly compromise the uniformity of the free surface of the wafer (in particular the uniformity of the thickness of the surface layer).

This drawback is furthermore increased if an important polishing is required, which would generally be the case in order to obtain low roughness values such as mentioned above.

According to a third known type of surface treatment, the wafer is exposed to a rapid thermal annealing (RTA), under a controlled atmosphere.

In this third type of known surface treatment, the wafer is annealed in a high temperature, e.g. in the order of 1100 to 1300° C, during a time which can run from about one second to a few tens of seconds.

According to a first variant of this third type of surface treatment, the free surface of the wafer is smoothed by a RTA of the wafer in an atmosphere made of a mixing generally containing hydrogen in combination with reactive gases (HCl, HF, HBr, SF6, CF4 NF3, CCl2F2,..).

US 6 171 965 gives an example of such variant. EP 1 061 565 also discloses a RTA (carried out under an hydrogen atmosphere).

In this first variant of the third known surface treatment, the reactivity of the mixed annealing atmosphere allows etching of the free surface of the wafer, which reduces its roughness.

This first variant can be regarded as advantageous.

An embodiment disclosed by EP 1 061 565 corresponds to this first variant of the third known type of a surface treatment.

In this embodiment, a RTA is carried out in an atmosphere which systematically comprises hydrogen.

However, a limitation of such variant derives from the fact that the annealing atmosphere is reactive.

Elements other than the free surface of the wafer which is to be annealed can thus be exposed to the action of such atmosphere (such elements can be e.g. the surface of the wafer which is opposed to the surface to be treated, walls of the annealing chamber....).

It can thus be necessary to use additional means to protect such elements. This tends to further complexity the process.

And the reactivity of the mixed atmosphere can also possibly further degrade some defaults of the wafer, which of course is undesired.

Furthermore, such variant can necessitate a specific installation (for e.g. feed the annealing device with the different gases, and/or ensure security....). This constitutes a further constraint.

According to a second variant of the third known type of surface treatment, the wafer is exposed to a RTA under an atmosphere which does not attack the material of the wafer.

In such variant, the smoothing is not obtained by etching the free surface of the wafer, but rather by reconstructing it.

The annealing atmosphere is in this case typically composed of hydrogen mixed with argon or nitrogen.

EP 1 158 581 discloses such a surface treatment. The treatment disclosed by this patent systematically comprises two different annealing steps, one of them being a RTA. These annealing steps can be carried out in an atmosphere containing hydrogen or argon.

The two annealing steps disclosed by this patent aim at smoothing the free surface of a wafer. The decrease of low frequency roughness is illustrated by the last column of table 2 of this patent, which in particular shows the effect of a second annealing after the RTA.

Indeed, according to this patent a single RTA ("exemple comparatif 1") leads to a low frequency roughness of 1,60 nm rms. By having this RTA followed by a subsequent additional annealing step, low frequency roughness is brought down to values of 0,28 and 0.30 nm rms.

EP 1 158 581 thus teaches two successive annealings, the first annealing being a RTA.

But the fact that the process disclosed by EP 158 581 systematically comprises two distinct annealing steps makes such process relatively long and complex.

US 2002/0127766 teaches a process for reducing damage on front and back surfaces of a wafer comprising a chemical cleaning followed by an RTA step in an atmosphere containing argon, nitrogen or oxygen.

An object of the invention is to improve the known surface treatment processes, such as mentioned above.

It would indeed be advantageous to further simplify, speed and ease such known processes.

Furthermore, it would also be advantageous to reduce possible slip lines such as the ones that can appear in the crystallographic structure of the material of the wafer, in particular after a thermal treatment (such as the thermal treatment applied to the wafer to cleave it in a Smart-Cut^{®}-type process).

Such slip lines can be generated by local differences in the heat budget received by different regions of the surface of the wafer (this being even more the case with annealing devices presenting cold points).

In addition, the hydrogen used in this variant is a volatile gas, which leads to the fact that significant amounts of hydrogen can be used - while it is constantly sought to diminish the cost associated to the surface treatment of wafers.

Finally, it would be particularly advantageous to implement a process fulfilling the above mentioned objectives, in combination with a Smart-Cut^{®}-type process.

WO 03/005434 brings an advantageous solution in order to meet the objectives mentioned above.

This document discloses a heat treatment which is a single annealing, carried out as a RTA under a pure argon atmosphere.

Such treatment reveals advantageous, as it improves surface roughness without being exposed to the drawbacks mentioned above in reference to other techniques.

The goal of the invention is to further improve this last treatment.

Indeed, if such treatment greatly reduces the mean value of the surface roughness of the treated wafer, some inhomogeneities still remain in the distribution of roughness over the surface of the wafer.

A further goal of the invention is thus to improve roughness homogeneity over the wafer surface.

It is indeed reminded that in the perspective of the surface treatment of the wafer the objective is to not only to reduce the mean value of the surface roughness of the wafer.

Indeed, it is also sought to obtain a roughness distribution which is as homogeneous as possible over the surface of the wafer.

In particular, it is desired to avoid obtaining a treated surface which present different regions corresponding to different values of roughness.

To reach the goals mentioned above, the invention proposes a process for reducing the roughness of the free surface of a semiconductor wafer as specified by claim 1.

Preferred, but non-limiting aspects of such a process are the following :
- for the SC1 bath the concentration in molecular weight of both NH4OH and H2O2 is between 1 % and 5 %,
- the wafer has a silicon surface slayer and the respective concentrations in molecular weight of NH4OH and H2O2 are 1 % and 2 %,
- for the SC2 bath the concentration in molecular weight of both HCl and H2O2 is between 0.1 % and 5 %,
- the wafer has a silicon surface layer and the respective concentrations in molecular weight of both HCl and H2O2 are 1 %,
- the temperature for the SC1 and SC2 bath is between 20 and 80°C,
- the wafer has a silicon surface layer and the temperature for the SC1 and SC2 bath is 70°C,
- said cleaning is a HF cleaning,
- for the HF bath the concentration in molecular weight of HF is between 0.1 % and 49 %,
- for the HF bath the concentration in molecular weight of HF is 20%,
- said RTA in a pure argon atmosphere is carried out at a temperature of 1150 to 1230 °C,
- said RTA in a pure argon atmosphere is carried out during one to 30 seconds,
- the process is carried out on a wafer obtained by a Smart-Cut^{®}-type process,
- the process is carried out on a SOI wafer,
- the process is carried out on a SGOI wafer having a surface layer in SiGe with a Ge concentration which is less than 20%.

Other aspects of the invention shall be apparent from the following description, made in reference to the drawings on which :
- Figure 1 is a general and schematical representation in longitudinal cut of an annealing chamber which can be used in the invention,
- Figure 2 is a graph illustrating the decrease of roughness obtained by a RTA carried out for the invention, on a silicon wafer,
- Figure 3 is a graph illustrating the evolution of temperature for a RTA carried out under an atmosphere of pure argon,
- Figure 4 is a graph illustrating the evolution of temperature for a thermal treatment according to an example, not forming part of the invention,
- Figures 5a and 5b illustrate the roughness distribution aver two respective wafers, the wafer of figure 5a having undergone a pure argon RTA without preliminary treatment, the wafer of figure 5b having furthermore undergone a preliminary treatment before the pure argon RTA.

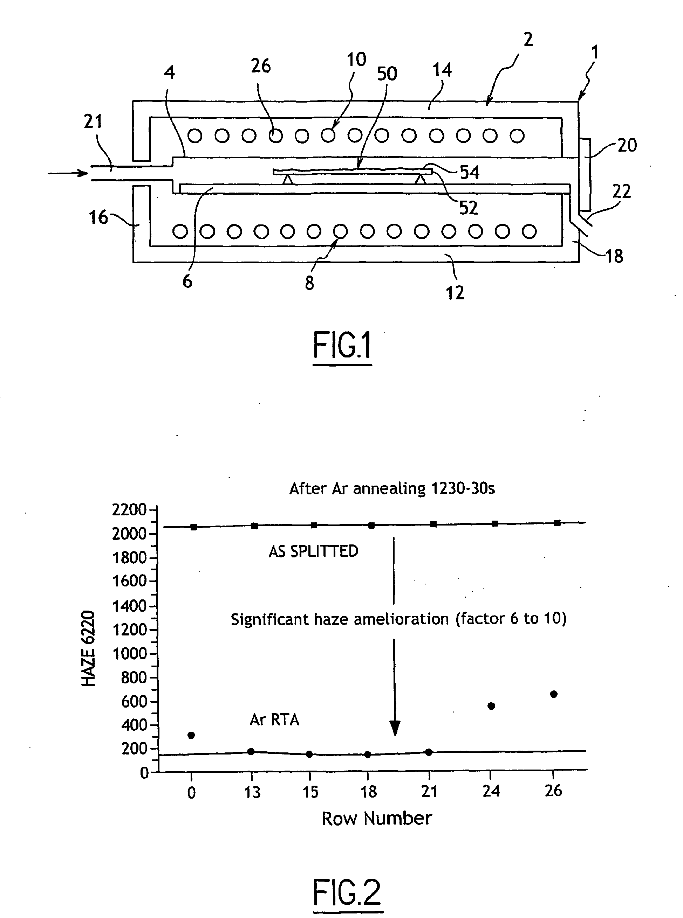

Figure 1 schematically shows a non-limiting example of an annealing chamber 1 which can be used for implementing the invention.

This chamber is to be used for a RTA thermal treatment, carried out under a 100% pure Argon atmosphere.

The chamber 1 comprises an inner space delimited by walls 2. It further comprises a reactor 4, a carrier 6 for carrying a wafer to be annealed, two networks 8, 10 of halogen lamps and two pairs of lateral lamps (not represented).

The walls 2 comprise in particular a lower wall 12, an upper wall 14 and two lateral walls 16, 18 located at the opposite longitudinal ends of the inner space.

One of the two lateral walls 16 comprises a door 20 for introducing/retrieving the wafer into/from the reactor.

Reactor 4 is made of a quartz tube which extends longitudinally between the lateral walls 16, 18. It is provided at each of these lateral walls 16, 18 respectively with a gas inlet 21 and a gas outlet 22. The gas outlet 22 is located on the side of the lateral wall 18 which comprises the door 20.

Each network of halogen lamps 8, 10 is located respectively above and under reactor 4, between said reactor and the lower and upper walls 12 and 14.

Each network of halogen lamps 8, 10 comprises in this embodiment seventeen lamps 26 collectively disposed orthogonally to the longitudinal axis of reactor 4.

The two pairs of lateral lamps (not represented on Figure 1) are disposed parallel to the longitudinal axis of reactor 4, each lamp being on one side of said reactor. Each of these lateral lamps is located near the longitudinal end of networks 8, 10.

The carrier 6 supports a wafer 50 which is to undergo a RTA under a pure Argon atmosphere. This carrier can slide into reactor 4, thus allowing introduction and extraction of the wafer into and from the reactor.

It is thus understood that the RTA of the invention is a single wafer heat treatment, the wafers being treated one at a time.

Non-limiting examples of devices which can be used as an annealing chamber of this type are e.g. the device "SHS AST 2800" sold by STEAG^{®}, or "Radiance^{®} devices from Applied Materials.

It is reminded that the wafer 50 can be any type of wafer, be it monolayer or multilayer, comprising at least a surface layer in a semiconductor material (such as e.g. silicon or silicon-germanium).

The invention can be used for improving the surface roughness of wafers 50 of any origin

In particular, the invention applies to improving the surface roughness of wafers of the SOI (Silicon On, Insulator) or SGOI (Silicon-Germanium On Insulator) type.

And the treated wafers can have been obtained e.g. by a Smart-Cut^{®}-type process.

Indeed, in combination with such a Smart-Cut^{®}-type process the invention can be used for improving the surface roughness of one or the other (or both) free surfaces generated by the cleaving step at the embrittlement zone.

Furthermore, the implantation of such Smart-Cut^{®}-type process can have been done by co-implantation of two (or more) different species. An example of such co-implantation in combination with a Smart-Cut^{®}-type process is given in the application FR 03 09304 in the name of the applicant.

And the different embodiments of the invention can be applied to a wafer 50 comprising a working surface layer 52 made in semiconductor material (e.g. silicon or silicon-germanium), said layer having a free surface 54.

Layer 52 is referred to as a "working" layer because it shall then be used for making electronic, optic or opto-electronic components on the wafer 50.

As mentioned above, surface 54 can have been generated by the cleaving step of a Smart-Cut^{®}-type process.

In such case, the wafer 50 comprises under the working layer 52 a buried oxide layer, which itself covers a support substrate.

On Figure 1, the thickness of wafer 50 has been exaggerated in order to show layer 52.

As mentioned above, the invention implies a single heat treatment of wafer 50 comprising a RTA carried out in a pure Argon atmosphere.

Such RTA comprises the following general operations :
- Introducing wafer 50 in the chamber 1, said chamber being "cold" (i.e. less than 400°C) at this time,
- Establishing in the chamber, at a pressure which is equal or close to the atmospheric pressure, an annealing atmosphere of pure Argon. The pressure can also be set to a lower value, from a few mTorr to the atmospheric pressure,
- Increasing the temperature in the chamber at a rate of about 50°C/s by selectively powering the halogen lamps 26, up to a RTA temperature,
- Maintaining wafer 50 in the chamber at a constant temperature, during a RTA duration (from about one second to a few tens of seconds),
- Shutting off lamps 26 and cooling, by air circulation, the wafer 50, at a rate of several tens of °C per second, and according to any desired cooling law.

In this respect, it is particularly important that the argon used be the purest possible since the applicant has determined that the presence (even in low quantities) of other elements (such as in particular oxygen) in the annealing atmosphere could generate an attack of the material of the working layer during the RTA.

"Pure" argon is thus understood in this text as argon containing less than 1 ppm of other elements (pollutants, other gases, ...).

For that purpose, the argon used must be treated in order to be purified before its introduction within the annealing chamber. Commercially available argon indeed does not present the high degree of purity which is required for the invention.

The purifying treatment can be carried out by purifiers and/or filters on the alimentation line which brings argon into the chamber.

An "attack" as mentioned above can correspond e.g. to a formation of SiO (which is very volatile) in the case of a Si working layer exposed to an annealing atmosphere containing a low quantity of oxygen.

The applicant has determined that such single heat treatment under the form of a RTA made in a pure Argon atmosphere significantly improved surface roughness of the wafer.

In particular, such RTA improves roughness much better than what would be obtained by a known thermal treatment such as sacrificial oxidation.

And furthermore, the uniformity of the working layer is much better than with a CMP treatment.

The RTA can comprise a constant temperature level having a duration of 1-30 s, at a temperature of e.g. 1100 to 1250°C.

Figure 2 illustrates the mean roughness diminution obtained by such RTA.

On this figure, the horizontal axis described different wafers, the haze of each wafer having been measured before such RTA (dots in the higher part of the graph), and after such RTA (dots in the lower part of the graph).

On figure 2 the higher curve thus corresponds to a haze measured on the surface of SOI wafers as splitted (immediately after cleaving), and the lower curve to the same kind of measure, after the same wafers have undergo a RTA under pure Argon with a 30s constant temperature at 1230°C.

It is specified that the term "haze" refers to an optical signal diffused by the light of wafer 50, in response to an excitation light. This haze is representative of the surface roughness.

In the case of Figure 2, this haze is measured using a KLA Tencor^{®} Surfscan 6220^{®} : the haze is thus here referred to as "haze 6220".

The observed diminution of haze is at least comparable to the results that could be obtained by other RTA techniques, e.g. RTA under an atmosphere comprising hydrogen mixed with argon.

More precisely, the haze is divided by a factor 6 to 10.

And in the case of the RTA of the invention, such advantageous results are obtained without the drawbacks exposed in introduction of this text, in reference to these known RTAs.

It should also be noted that argon has excellent thermal conductivity properties.

This tends to favour an homogeneous repartition of heat in the annealing chamber, and consequently :
- A more homogenous roughness distribution, and
- a diminution of the risk of slip lines.

The specific RTA used in the invention allows a very good smoothing of the free surface of the wafer. It should be noted that such smoothing is obtained with practically no erosion of material of the wafer 50, but rather by a reconstruction of the surface.

The invention furthermore implies a preliminary treatment of the wafer surface before the specific RTA described above.

The applicant has indeed observed that if such specific RTA (as generally disclosed in WO 03/005434) was very advantageous, it was still possible to further improve the surface roughness of the wafer in terms of roughness homogeneity.

In the absence of such preliminary treatment, it could indeed be possible to obtain a wafer surface with some regions having a slightly higher roughness than other regions (such "rougher" regions being typically located in the centre of the surface of the wafer).

Such possible variations in surface roughness are due to the presence of pollutants on the surface of the wafer, before carry outing the pure argon RTA.

Indeed, it is reminded that the RTA annealing of the invention is a wafer-by-wafer annealing.

In an industrial exploitation of such annealing, successive wafers will undergo the RTA in the same chamber, one after the other.

Therefore, when a wafer is introduced within the chamber to undergo RTA, it is desirable that the atmosphere of the chamber be as free as possible of elements (such as residual gases) produced by the opening of the chamber door when introducing the next wafer to be treated..

The atmosphere of the chamber after opening the chamber door can indeed contain gases such as 02, CO2, etc.. as well as H2O vapour. Such remaining gases are undesirable in the chamber for the next RTA to be carried out.

After opening the chamber and closing it again after introduction of the wafer to be treated, it is thus necessary to purge the atmosphere of the chamber before carry outing the next RTA on another wafer.

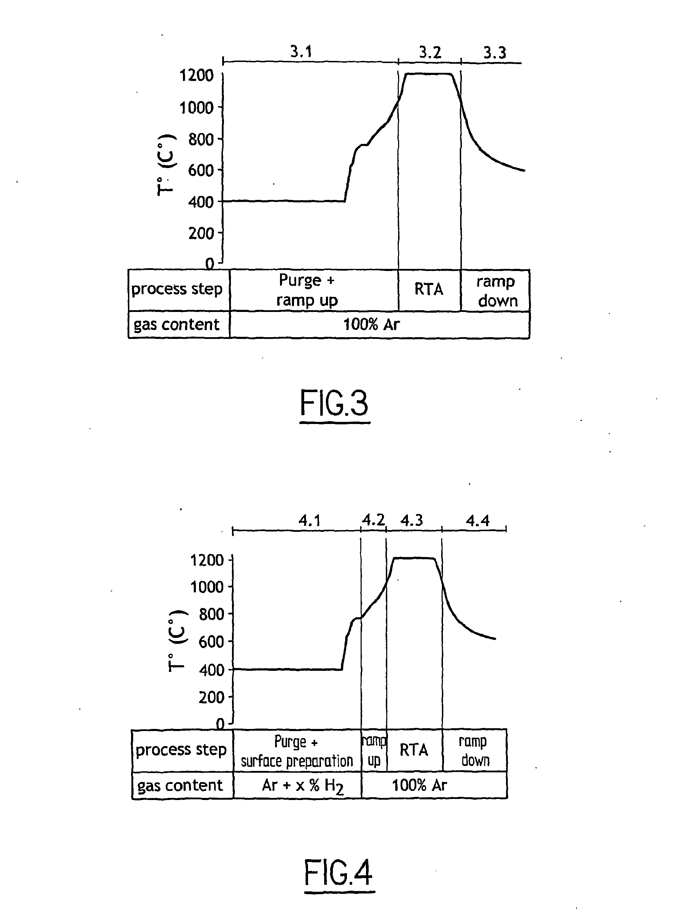

Figure 3 globally illustrates a single annealing carried out as a pure argon RTA (this constituting a base for the improvement proposed by the invention).

This annealing comprises an initial phase 3.1 of the heat treatment which corresponds to a purge of the atmosphere of the chamber, and to the ramp-up in temperature from the "cold" temperature of the chamber (i.e. less than 400°C - it is indeed specified that the temperature sensor used for building the graphs of Figures 3 and 4 indicates a fixed value of 400°C for temperatures which are in fact less than 400°C, and the actual value of temperature only for temperatures which are more than 400°C).

The initial phase 3.1 is followed by :
- A RTA during 1 to 30 s (phase 3.2), at 1150-1230°C,
- A cooling (phase 3.3).

In the initial phase 3.1, the ramp-up is carried out with two main steps :
- A first step up from 400°C to a pre-stabilisation temperature of about 750°C,
- A second step from the pre-stabilisation temperature to the RTA temperature (between 1150 and 1230 °C).

During this initial phase, a purge of the atmosphere of the chamber has been carried out, in order to evacuate undesirable gases.

This purge is a classical purge, with an evacuation of the atmosphere introduced within the chamber together with the wafer, and the establishment of a pure argon atmosphere.

The table at the bottom part of figures 3 and 4 indicates the process step, as well as the gas composition within the annealing chamber.

In the case of figure 3, the atmosphere is thus composed of pure argon during the whole process.

And the initial purge has allowed to evacuate from the annealing atmosphere pollutants which could generate variations in surface roughness after the pure argon RTA.

The applicant has however determined that the pollutants which can generate variations in surface roughness after the pure argon RTA can be not only elements present in the initial atmosphere in the annealing chamber, but also elements present on the wafer surface even before introducing the wafer in the annealing chamber.

Indeed, the applicant has observed that even with an initial purge of the annealing chamber before a pure argon RTA, some variations in roughness are still to be observed on the treated wafers.

For the purpose of clarity, such elements present on the wafer surface and which could generate variations in surface roughness after the pure argon RTA shall herein be referred to as "preliminary pollutants".

Such preliminary pollutants can be in particular a native oxide on the wafer surface, or other pollutants such as hydrocarbons.

The invention therefore provides a preliminary treatment before the pure argon RTA in order to eliminate the undesirable effects associated to the preliminary pollutants, and improve surface roughness even more than with a pure argon RTA (in particular in terms of homogeneity).

Two main examples of such preliminary treatment are discussed.

Each of these two examples corresponds to a single annealing, carried out as a pure argon RTA. These examples propose two respective preliminary treatments to be carried out in association with such single annealing.

These two examples can be implemented as alternatives. They can also be combined together.

According to a first example of the preliminary treatment, not forming part of the invention, the initial purge of the annealing chamber is combined with a controlled enrichment of the atmosphere within the annealing chamber.

This example is illustrated on Figure 4.

In this first example, during the initial phase of the annealing (phase 4.1 on Figure 4), the chamber is not only purged, but also filled with a controlled atmosphere comprising argon and a controlled proportion of a secondary gas.

The secondary gas can be in particular hydrogen, HCl, or a mixture of both.

On figure 4, the secondary gas is hydrogen (see table below the graph).

The "controlled proportion" is generally between 0.5 and 30 %.

More precisely, if the secondary gas is hydrogen, the "controlled proportion" should be between 0.5 and 30 %.

If the secondary gas is HCl, the "controlled proportion" should be between 0.5 and 5 %.

If the secondary gas is a mixture of hydrogen and HCl, the "controlled proportion" should be between 0.5 % and a percentage between 5 and 30 %, depending on the ratio (hydrogen/HCl) in the secondary gas.

It is to be noted that with the injection of a secondary gas, the "initial" phase 4.1 is limited in time to the purge and the initial raise in temperature - up to the pre-stabilisation temperature of about 750°C (this temperature being too low for a smoothing to occur).

This initial phase 4.1 allows to eliminate (or at least drastically reduce) the preliminary pollutants.

In this example, the preliminary treatment is carried out in the same general operation that the RTA itself.

It should however be noted that this initial phase 4.1 does not correspond to a pre-anneal, since the temperature is very low (less than 400°C - and sometimes even significantly less, since this initial phase can be carried out at temperatures which can typically be between 100 and 400°C). Phase 4.1 is a controlled purge phase.

Once this pre-stabilisation temperature has been reached, the atmosphere of the chamber is changed so as to eliminate all secondary gas, and have a pure argon atmosphere for the ramp-up to the RTA temperature (phase 4.2), and the RTA itself (phase 4.3).

The RTA is essentially the same as the one described above in reference to figure 3 (phase 3.2).

Finally, a cooling phase 4.4 ends the process. It is similar to phase 3.3 mentioned in reference to figure 3.

In this example, the secondary gas injected in the initial phase 4.1 favors the elimination of the preliminary pollutants (in particular native oxide) from the wafer surface, during the initial phase 4.1.

A wafer having undergone such preliminary treatment can then be subject to a pure argon RTA : not only will the roughness of the wafer surface be significantly reduced, but furthermore this roughness will be homogeneous over the wafer surface.

This is illustrated by the following table, which shows surface roughness after the pure argon RTA for two SOI wafers (wafer 1 and wafer 2), and for three modes of roughness measurements - from a scanned surface of 2x2 µm² to a scanned surface of 40x40 µm².

| | ***AFM roughness (Angström rms)*** | | |
|---|---|---|---|
| | 2x2 µm² | 10x10 µm² | 40x40 µm² |
| Wafer 1 : Standard roughness region | 1.5 | 5 | 7 |
| Wafer 1 : High roughness region (no preliminary treatment) | 6.2 | 11.7 | 13.7 |
| Wafer 2 : Whole wafer surface | 1.5 | 5 | 7 |

In this table, wafer 1 has not undergone any preliminary treatment before the pure argon RTA.

The surface of this wafer 1 exhibits two different regions :
- A "Standard roughness region" with a surface roughness kept at a low level,
- A "High roughness region" with a substantially higher roughness..

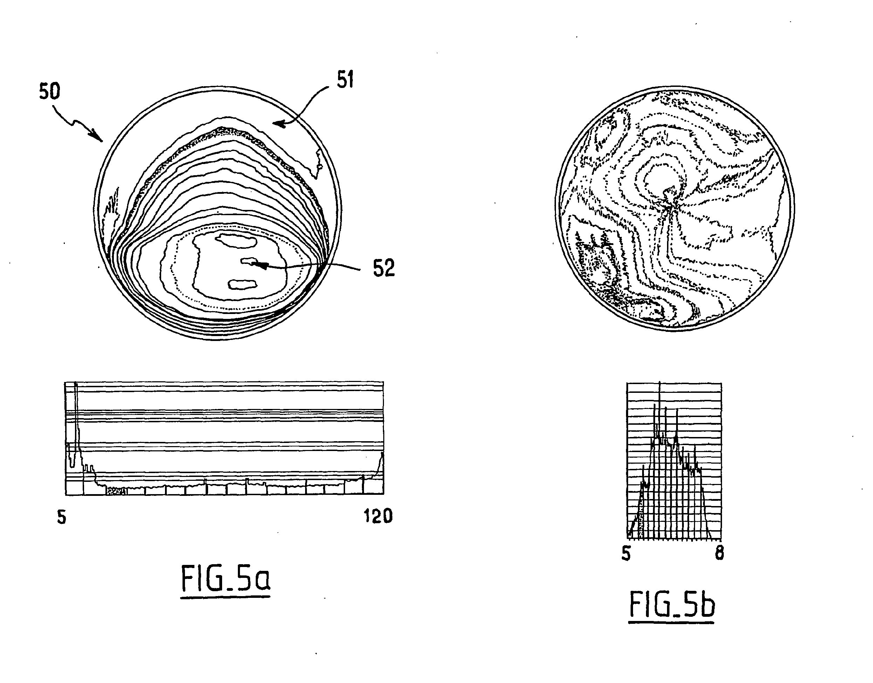

Figure 5a illustrates the roughness distribution over the surface of a wafer after a pure argon RTA. The upper part of the figure shows the haze repartition over the wafer surface.

The wafer 50 illustrated in figure 5a is representative of the "wafer 1" mentioned above, as it has not undergone any preliminary treatment before the pure argon RTA.

In the lower part of figure 5a, an histogram summarizes the distribution of haze values (directly related to roughness values).

This figure shows that the roughness values are widely distributed (from 5 to 120 ppm - see histogram).

And the upper part of the figure exhibits a higher roughness region 52, located in the lower central part of the wafer. The region 51 is on the contrary a lower roughness region.

The wafer illustrated on figure 5a is thus associated to a wide distribution of roughness, and to marked higher roughness regions.

Wafer 2 of the above table has undergone a preliminary treatment (according to the first example described above).

This wafer is illustrated on figure 5b, which is a representation similar to the representation of figure 5a for wafer 1.

It can be seen that this wafer 2 does not exhibit any "High roughness region" - after the pure argon RTA the low surface roughness is indeed evenly distributed on the wafer (see in particular the histogram in the lower part of figure 5b).

The preliminary treatment is thus advantageous as it significantly enhances roughness homogeneity.

It is furthermore convenient, because it takes advantage of the necessary purge phase before the RTA. No additional step is thus required.

According to a second example of the preliminary treatment which is also an embodiment of the present invention, prior to the pure argon RTA the wafer is subjected to a preliminary treatment carried out under the form of a chemical cleaning of the wafer surface.

Here again, the wafer can be in particular (though this is non limiting of the scope of the invention) a SOI or SGOI wafer. And it can have been obtained by a Smart-Cut^{®}-type process.

The cleaning is carried out immediately before introducing the wafer in the annealing chamber.

This cleaning allows the elimination of the preliminary pollutants. This improves the roughness observed after the pure argon RTA - in particular in terms of homogeneity.

The cleaning is a RCA cleaning, or, in one example not forming part of the invention, a HF cleaning.

A RCA cleaning comprises two successive chemical bathes.

A first bath is made into a SC1 solution (aqueous solution of NH4OH and H2O2).

The applicant has found that the concentration of both NH4OH and H2O2 must be between 1 % and 5 % (molecular weight).

More precisely, for the preliminary treatment of a wafer having a silicon surface layer (e.g. a SOI), preferred concentrations are 1% for NH4OH and 2% for H2O2.

A second bath is then made into a solution of SC2 (aqueous solution of HCl and H2O2).

The applicant has found that the concentration of both HCl and H2O2 must be between 0.1 % and 5 % (molecular weight).

More precisely, for the preliminary treatment of a wafer having a silicon surface layer (e.g. a SOI), preferred concentrations are 1% for HCl and 1 % for H2O2.

The temperature for the SC1 and SC2 bath should preferably between 20 and 80°C, more preferably 70°C for a wafer having a silicon surface layer.

A HF cleaning shall in particular etch the native oxide SiO2 than can be present on the wafer surface.

The applicant has found that the concentration of HF must be between 0.1 % and 49 % (molecular weight). A HF concentration which is well-adapted is 20%.

The HF bath should preferably be carried out at room temperature (about 20°C).

In both cases (RCA and HF cleaning), the cleaning can be combined with rinsing steps. However, in the case of a HF cleaning, no rinsing should preferably be done after the cleaning.

As mentioned above, in this second example also the wafer to be treated can be in particular a SOI or SGOI wafer.

It is to be noted that in the case of a wafer having a surface layer in SiGe, the concentration of Ge in said layer should preferably be no more than 20%.

Moreover, generally speaking (be it for the RCA or HF cleaning, or for the other possible types of chemical cleaning), the parameters of the preliminary treatment under the form of a chemical cleaning shall be set so as to have a less aggressive cleaning for a SGOI wafer than for a SOI wafer.

Such adaptation of the cleaning for a SGOI wafer is obtained in particular by :
- Adopting cleaning agents which are more diluted, and/or
- Setting the temperature to a lower value for the cleaning.

Both examples described above allow to further improve the general process disclosed in WO 03/005434.

In particular, the surface roughness of a wafer treated by one of these embodiments is :
- Even further reduced, and
- More evenly distributed (in particular, no higher roughness region is observed in the central region of the wafer).

## Claims

1. Process for reducing the roughness of the free surface of a semiconductor wafer comprising a working surface layer and, under the working surface layer, a buried oxide layer which covers a support substrate, said process comprising a single annealing step for smoothing said free surface, said single annealing step being carried out as a RTA under an atmosphere of argon, wherein argon is submitted to a purifying treatment carried out by purifiers and/or filters on an alimentation line which brings argon into the chamber so that argon is purified before its introduction within the annealing chamber to contain less than 1 ppm of other elements, and in that before the RTA, immediately before introducing the wafer in the annealing chamber, a RCA chemical cleaning of the free surface is carried out so as to reduce the amount of preliminary pollutants present on the free surface that could generate variations in surface roughness after the RTA, said RCA cleaning comprising a SC1 bath followed by a SC2 bath.

2. Process according to claim 1, wherein the working surface layer originates from a donor wafer which has undergone the steps of (i) implanting species in an implantation region of the donor wafer, (ii) contracting the implanted donor wafer to said support substrate and (iii) cleaving the donor wafer at the implantation region,

3. Process according to one of claims 1-2, **characterized in that** for the SC1 bath the concentration in molecular weight of both NH₄0H and H₂O₂ is between 1 % and 5 %,

4. Process according to the claim 3, wherein the working surface layer is a silicon surfaces layer and the respective concentrations in molecular weight of NH₄0H and H₂O₂ are 1 % and 2 %.

5. Process according to one of claims 1-4, **characterized in that** for the SC2 bath the concentration in molecular weight of both HCl and H₂O₂ is between 0.1 % and 5 %.

6. Process according to the clam 5, wherein the working surface layer is a silicon surface layer and the respective concentrations in molecular weight of both HCl and H₂O₂ are 1%.

7. Process according to one claims 1-6, **characterized in that** the temperature for the SC1 and SC2 bath is between 20 and 80°C.

8. Process according to claim 7, wherein the working surface layer is a silicon surface layer and the temperature for the SC1 and SC2 bath is 70°C.

9. Process according to one of claims 1-8. **characterized in that** before the RTA the atmosphere of the annealing environment is purged and filled with a controlled atmosphere containing argon mixed with a secondary gas which can be hydrogen and/or HCl, allowing further reduction of preliminary pollutants,

10. Process according to any one of claims 1-9, **characterized in that** said RTA in a pure argon atmosphere is carried out at a temperature of 1150 to 1230°C.

11. Process according to any one of claims 1-10, **characterized in that** said RTA in a pure argon atmosphere is carried out during one to 30 seconds.

12. Process according to one of claims 1-11, **characterized in that** it is carried out on a SOI wafer.

13. Process according to any one of claims 1-11, **characterized in that** it is carried out on a SGOI wafer having a surface layer in SiGe with a Ge concentration which is less than 30%.

## Patentansprüche

1. Verfahren zum Verringern der Rauhigkeit der freien Oberfläche eines Halbleiterwafers, der eine Arbeitsoberflächenschicht und, unter der Arbeitsoberflächenschicht, eine vergrabene Oxidschicht, welche ein Stützsubstrat abdeckt, aufweist, wobei das Verfahren einen einzigen Wärmebehandlungsschritt zum Glätten der freien Oberfläche aufweist, wobei der einzige Wärmebehandlungsschritt als RTA unter Argonatmosphäre ausgeführt wird, wobei das Argon einer Reinigungsbehandlung unterzogen wird, die durch Reiniger und/oder Filter an einer Speiseleitung, welche Argon der Kammer zuführt, ausgeführt wird, so dass das Argon vor dessen Einspeisung in die Wärmebehandlungskammer derart gereinigt ist, dass es weniger als 1 ppm von anderen Elementen enthält, wobei vor Ausführung des RTA, unmittelbar vor dem Einführen des Wafers in die Wärmebehandlungskammer, eine chemische RCA-Reinigung der freien Oberfläche ausgeführt wird, um die Menge der vorausgehenden Verunreinigungen, die an der freien Oberfläche vorliegen, die Veränderungen der Oberflächenrauhigkeit nach der RTA verursachen könnten, zu verringern, wobei die RCA-Reinigung ein SC1-Bad gefolgt von einem SC2-Bad aufweist.

2. Verfahren gemäß Anspruch 1, wobei die Arbeitsoberflächenschicht von einem Donor-Wafer stammt, welcher den folgenden Schritten unterzogen wurde: (i) Implantieren von Spezies in einem Implantationsbereich des Donor-Wafers, (ii) In-Berührung-bringen des mit Spezies implantierten Donor-Wafers mit einem Stützsubstrat und (iii) Spalten des Donor-Wafers an dem Implantationsbereich.

3. Verfahren gemäß einem der Ansprüche 1 oder 2, **dadurch gekennzeichnet, dass** für das SC1-Bad die Molekulargewichtskonzentration von sowohl NH₄OH als auch H₂O₂ zwischen 1% und 5% liegt.

4. Verfahren gemäß Anspruch 3, wobei die Arbeitsoberflächenschicht eine Siliziumoberflächenschicht ist und die entsprechenden Molekulargewichtskonzentrationen von NH₄OH und H₂O₂ 1% und 2% sind.

5. Verfahren gemäß einem der Ansprüche 1 bis 4, **dadurch gekennzeichnet, dass** für das SC2-Bad die Molekulargewichtskonzentration von sowohl HCl als auch H₂O₂ zwischen 0,1% und 5% liegt.

6. Verfahren gemäß Anspruch 5, wobei die Arbeitsoberflächenschicht eine Siliziumoberflächenschicht ist und die entsprechenden Molekulargewichtskonzentrationen von sowohl HCl als auch H₂O₂ 1% sind.

7. Verfahren gemäß einem der Ansprüche 1 bis 6, **dadurch gekennzeichnet, dass** die Temperatur für das SC1- und SC2-Bad zwischen 20°C und 80°C liegt.

8. Verfahren gemäß Anspruch 7, wobei die Arbeitsoberflächenschicht eine Siliziumoberflächenschicht ist und die Temperatur für das SC1- und SC2-Bad 70°C ist.

9. Verfahren gemäß einem der Ansprüche 1 bis 8, **dadurch gekennzeichnet, dass** vor der Ausführung des RTA die Atmosphäre der Wärmebehandlungsumgebung gereinigt und mit einer kontrollierten Atmosphäre gefüllt wird, die Argon gemischt mit einem Sekundärgas, welches Wasserstoff und/oder HCl sein kann, enthält, wodurch eine weitere Verringerung der vorhergehenden Verunreinigungen ermöglicht wird.

10. Verfahren gemäß einem der Ansprüche 1 bis 9, **dadurch gekennzeichnet, dass** das RTA in einer reinen Argonatmosphäre bei einer Temperatur von 1150°C bis 1230°C ausgeführt wird.

11. Verfahren gemäß einem der Ansprüche 1 bis 10, **dadurch gekennzeichnet, dass** das RTA in einer reinen Argonatmosphäre innerhalb von 1 bis 30 Sekunden ausgeführt wird.

12. Verfahren gemäß einem der Ansprüche 1 bis 11, **dadurch gekennzeichnet, dass** es an einem SOI-Wafer ausgeführt wird.

13. Verfahren gemäß einem der Ansprüche 1 bis 11, **dadurch gekennzeichnet, dass** es an einem SGOI-Wafer, der eine SiGe-Oberflächenschicht mit einer Ge-Konzentration von weniger als 20% hat, ausgeführt wird.

## Revendications

1. Procédé de réduction de la rugosité de la surface libre d'une tranche semi-conductrice comprenant une couche de surface de travail et, sous la couche de surface de travail, une couche d'oxyde enterré qui couvre un substrat de support, ledit procédé comprenant une étape de recuit unique pour lisser ladite surface libre, ladite étape de recuit unique étant réalisée sous forme de RTR (recuit thermique rapide) dans une atmosphère d'argon, l'argon étant soumis à un traitement de purification réalisé par des purificateurs et/ou filtres sur une ligne d'alimentation qui amène l'argon dans la chambre de sorte que l'argon est purifié avant son introduction dans la chambre de recuit pour contenir moins de 1 ppm d'autres éléments, et en ce qu'avant le RTR, immédiatement avant l'introduction de la tranche dans la chambre de recuit, un nettoyage chimique RCA de la surface libre est réalisé de façon à réduire la quantité de polluants préliminaires présents sur la surface libre qui pourraient générer des variations de rugosité de surface après le RTR, ledit nettoyage RCA comprenant un bain de SC1, suivi par un bain de SC2.

2. Procédé selon la revendication 1, dans lequel la couche de surface de travail provient d'une tranche donneuse qui a subi les étapes consistant à (i) implanter une espèce dans une région d'implantation de la tranche donneuse, (ii) mettre en contact la tranche donneuse implantée avec ledit substrat de support et (iii) cliver la tranche donneuse au niveau de la région d'implantation.

3. Procédé selon l'une des revendications 1 ou 2, **caractérisé en ce que** pour le bain de SC1, la concentration en masse moléculaire de NH₄OH et H₂O₂ ensemble est comprise entre 1 % et 5 %.

4. Procédé selon la revendication 3, dans lequel la couche de surface de travail est une couche de surface en silicium et les concentrations respectives en masse moléculaire de NH₄OH et H₂O₂ sont de 1 % et 2 %.

5. Procédé selon l'une des revendications 1 à 4, **caractérisé en ce que**, pour le bain de SC2, la concentration en masse moléculaire de HCl et H₂O₂ ensemble est comprise entre 0,1 % et 5 %.

6. Procédé selon la revendication 5, dans lequel la couche de surface de travail est une couche de surface en silicium et les concentrations respectives en masse moléculaire de HCl et H₂O₂ ensemble sont de 1 %.

7. Procédé selon l'une des revendications 1 à 6, **caractérisé en ce que** la température pour le bain de SC1 et de SC2 est comprise entre 20 et 80 °C.

8. Procédé selon la revendication 7, dans lequel la couche de surface de travail est une couche de surface en silicium et la température pour le bain de SC1 et de SC2 est de 70 °C.

9. Procédé selon l'une des revendications 1 à 8, **caractérisé en ce qu'**avant le RTR, l'atmosphère de l'environnement de recuit est purgée et remplie d'une atmosphère régulée contenant de l'argon mélangé avec un gaz secondaire qui peut être l'hydrogène et/ou HCl, permettant une réduction supplémentaire des polluants préliminaires.

10. Procédé selon l'une quelconque des revendications 1 à 9, **caractérisé en ce que** ledit RTR dans une atmosphère d'argon pur est réalisé à une température de 1 150 à 1 230 °C.

11. Procédé selon l'une quelconque des revendications 1 à 10, **caractérisé en ce que** ledit RTR dans une atmosphère d'argon pur est réalisé pendant une à 30 secondes.

12. Procédé selon l'une des revendications 1 à 11, **caractérisé en ce qu'**il est réalisé sur une tranche de SOI.

13. Procédé selon l'une quelconque des revendications 1 à 11, **caractérisé en ce qu'**il est réalisé sur une tranche de SGOI ayant une couche de surface en SiGe avec une concentration en Ge qui est inférieure à 20 %.
